# EUROPEAN PATENT APPLICATION

(11) **EP 4 012 628 A1**
(43) Date of publication of application: **15.06.2022**
(21) Application number: 21196609.8
(22) Date of filing: 14.09.2021
(51) Int. Cl.: G06N 10/40

(54) **OPTICAL COMMUNICATION IN QUANTUM COMPUTING SYSTEMS**

(30) Priority: 11.12.2020 US 202017119535
(71) Applicant: INTEL Corporation, Santa Clara, CA 95054 (US)
(72) Inventor: AL-HEMYARI, Kadhair, Santa Clara, 95050 (US); MLADENOV, Todor M, Portland, 97221 (US); MATSUURA, Anne Y, Portland, 97209 (US)
(74) Representative: HGF

(57) **Abstract**

Disclosed herein are assemblies for optical communication in quantum computing. For example, in some embodiments, a quantum computing assembly may include control circuitry having an optical interface to external electronic circuitry.

## Description

### Background

Quantum computing refers to the field of research related to computation systems that use quantum mechanical phenomena to manipulate data. These quantum mechanical phenomena, such as superposition (in which a quantum variable can simultaneously exist in multiple different states) and entanglement (in which multiple quantum variables have related states irrespective of the distance between them in space or time), do not have analogs in the world of classical computing, and thus cannot be implemented with classical computing devices.

### Brief Description of the Drawings

Embodiments will be readily understood by the following detailed description in conjunction with the accompanying drawings. To facilitate this description, like reference numerals designate like structural elements. Embodiments are illustrated by way of example, not by way of limitation, in the figures of the accompanying drawings.
FIG. 1 is a block diagram of an example quantum computing system including optical communication, in accordance with various embodiments.
FIG. 2 is a block diagram of example quantum computing control circuitry with an optical interface, in accordance with various embodiments.
FIGS. 3-5 are block diagrams of example embodiments of portions of an optical interface for control circuitry in a quantum computing system, in accordance with various embodiments.
FIG. 6 is a block diagram of an example superconducting qubit-type quantum device, in accordance with various embodiments.
FIG. 7 illustrates an example physical layout of superconducting qubit-type quantum devices, in accordance with various embodiments.
FIGS. 8A-8C are cross-sectional views of a spin qubit-type quantum device, in accordance with various embodiments.
FIGS. 9A-9C are cross-sectional views of various examples of quantum well stacks that may be used in a spin qubit-type quantum device, in accordance with various embodiments.
FIG. 10 is a top view of a wafer and dies that may be included in any of the quantum computing assemblies disclosed herein.
FIG. 11 is a block diagram of an example quantum computing system that may include any of the quantum computing assemblies disclosed herein, in accordance with various embodiments.

### Detailed Description

Disclosed herein are assemblies for optical communication in quantum computing (QC). For example, in some embodiments, a QC assembly may include control circuitry having an optical interface to external electronic circuitry (e.g., computing circuitry or other control circuitry).

The embodiments disclosed herein may address a number of the outstanding challenges in developing a QC system with a sufficient number of qubits to be able to solve commercially relevant computational problems. Some conventional QC systems may operate at cryogenic temperatures within a dilution refrigerator. The ability of such a refrigerator to dissipate heat generated at such low temperatures is extremely limited; for example, a dilution refrigerator may be constrained to dissipate only 1.8 watts of heat at a temperature of 4 kelvin, and only 50 milliwatts of heat at a temperature of 10 millikelvin. The communication interface between external electronic equipment at room temperature and the quantum electronics at cryogenic temperatures (e.g., using high-speed radio frequency (RF) metal cables with RF signals, or using digital serial interfaces over RF metal cables) is a major source of heat and noise transfer in conventional QC systems. Although RF cables may reduce the noise and provide higher data throughput at higher frequencies than individual metal wires, these cables typically require multiple thermal and noise isolation stages for reaching the cryogenic electronics, and further require large and power-intensive impedance matching circuitry for adequate performance. Additionally, RF cables are bulky, and thus parallel communication interfaces are typically not possible due to space limitations. Direct modulated serial interfaces, such as Serial Peripheral Interface (SPI), Universal Asynchronous Receiver-Transmitter (UART), or Inter-Integrated Circuit (I2C), may require few RF cables, but may provide extremely low data bandwidth. High-speed serial interfaces, such as Peripheral Component Interconnect Express (PCIE), Universal Serial Bus (USB), or Ethernet, may provide high-speed serial communication, but may require a large dedicated physical layer signal processing modules to drive the signals in the cryogenic refrigerator; using such interfaces may reduce the useful power budget for the quantum electronics, and may introduce challenges with noise in thermal isolation. Further, high-speed serial interfaces may not efficiently span the distances that typically separate cryogenic refrigerators without large (and bulky) amplifiers. Serializers/deserializers (SERDES) circuits typically require substantial isolation in a cryogenic environment, limiting their maximum useful throughput. Thus, as communications between external electronic equipment and the quantum electronics may serve as a substantial bottleneck in the efficient movement of data between different sets of quantum electronics, conventional QC systems may not be readily scaled to solve problems of practical importance.

In the following detailed description, reference is made to the accompanying drawings that form a part hereof wherein like numerals designate like parts throughout, and in which is shown, by way of illustration, embodiments that may be practiced. It is to be understood that other embodiments may be utilized, and structural or logical changes may be made, without departing from the scope of the present disclosure. Therefore, the following detailed description is not to be taken in a limiting sense.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The drawings are not necessarily to scale. Although many of the drawings illustrate rectilinear structures with flat walls and right-angle corners, this is simply for ease of illustration, and actual devices made using these techniques will exhibit rounded corners, surface roughness, and other features.

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. The terms "top" and "bottom" may be used herein to explain various features of the drawings, but these terms are simply for ease of discussion, and do not imply a desired or required orientation. As used herein, the term "insulating" means "electrically insulating," unless otherwise specified.

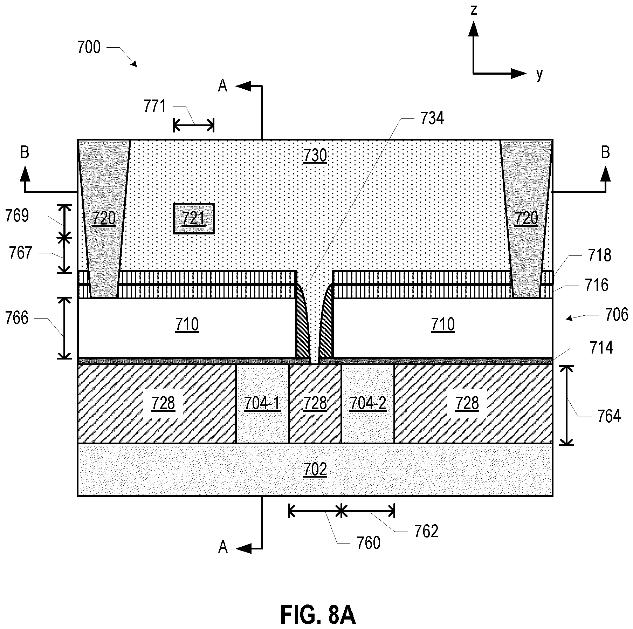

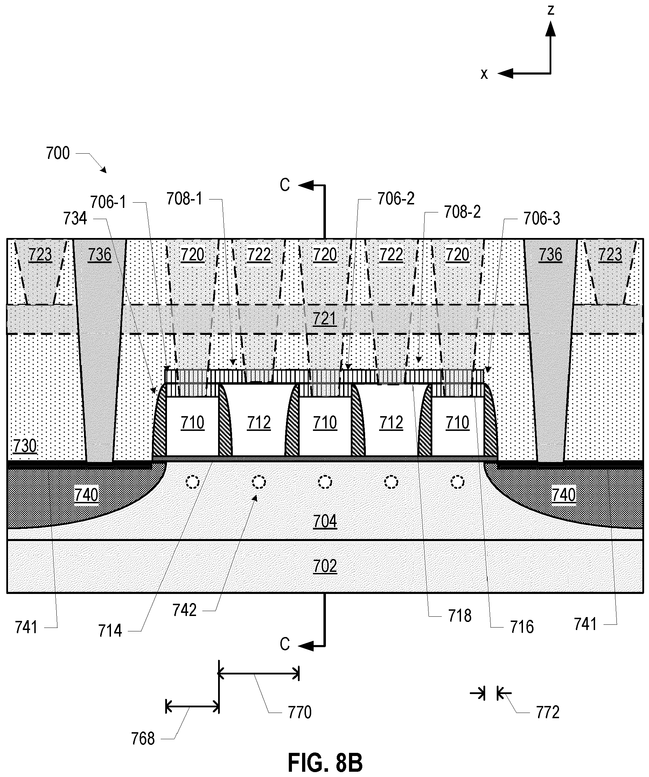

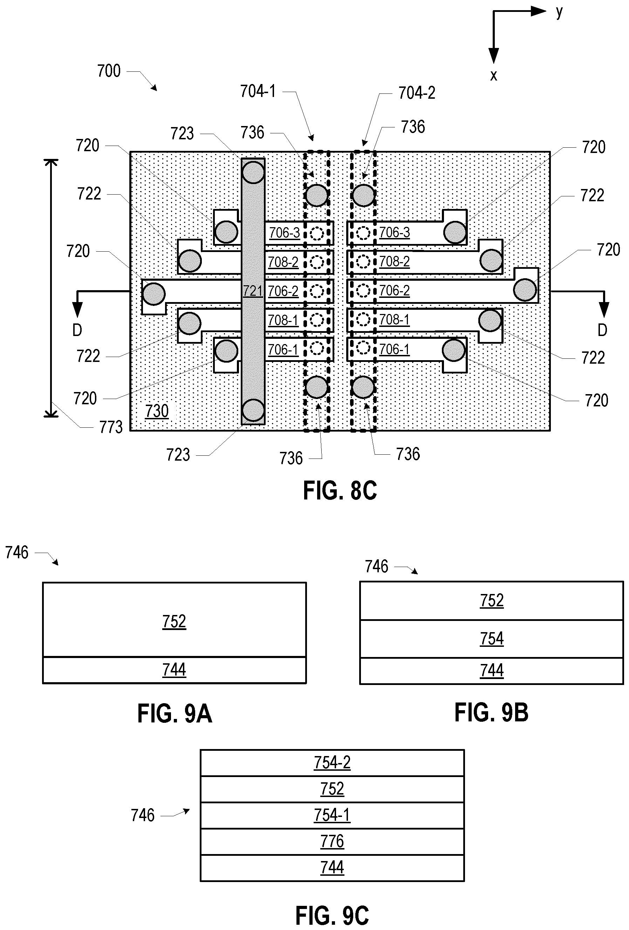

When used to describe a range of dimensions, the phrase "between X and Y" represents a range that includes X and Y. For convenience, the phrase "FIG. 8" may be used to refer to the collection of drawings of FIGS. 8A-8C, and the phrase "FIG. 9" may be used to refer to the collection of drawings of FIGS. 9A-9C. Although certain elements may be referred to in the singular herein, such elements may include multiple subelements. For example, "an insulating material" may include one or more insulating materials. As used herein, a "conductive contact" may refer to a portion of conductive material (e.g., metal) serving as an electrical interface between different components; conductive contacts may be recessed in, flush with, or extending away from a surface of a component, and may take any suitable form (e.g., a conductive pad or socket, or portion of a conductive line or via).

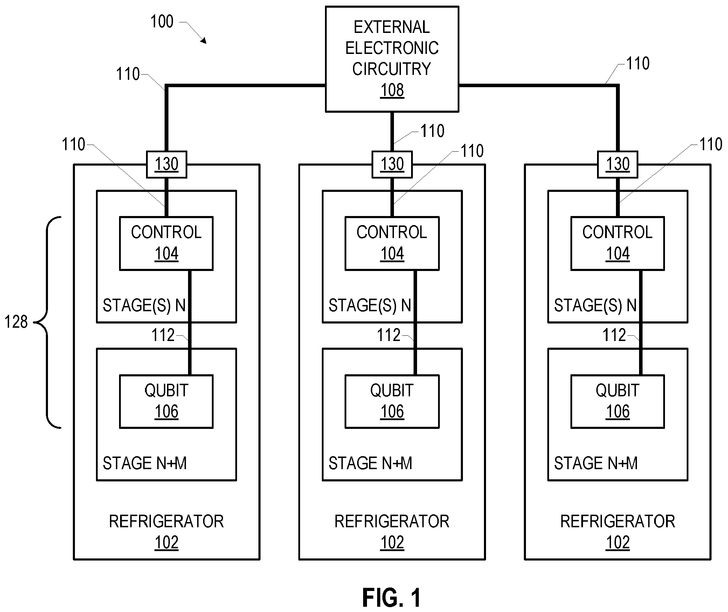

FIG. 1 is a block diagram of an example QC system 100 including optical communication, in accordance with various embodiments. The QC system 100 may include one or more refrigerators 102 with QC circuitry therein under vacuum. In particular, an individual refrigerator 102 may include a QC module 128 having qubit circuitry 106 and control circuitry 104. A refrigerator 102 may be configured to maintain the qubit circuitry 106 and the control circuitry 104 at predetermined low temperatures (e.g., at 5 kelvin or lower). In some embodiments, a refrigerator 102 may be, for example, a dilution refrigerator, a helium-3 refrigerator, or a liquid helium refrigerator.

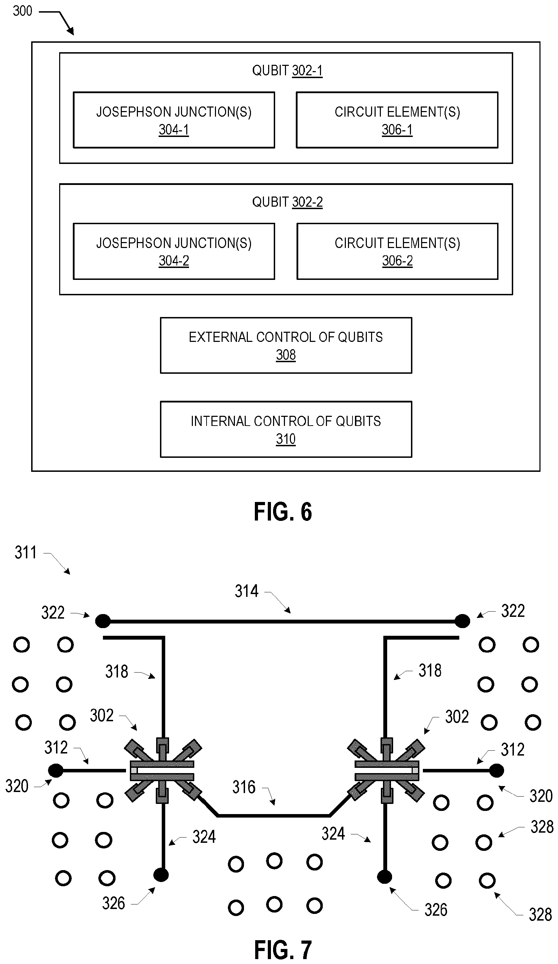

In a QC module 128, the qubit circuitry 106 may perform quantum processing operations, while the control circuitry 104 may include one or more non-quantum circuits for controlling the operation of the associated qubit circuitry 106 (e.g., by controlling the provision of signals to the qubit circuitry 106, such as radio frequency (RF) and/or microwave control signals). In some embodiments, the control circuitry 104 may provide peripheral logic to support the operation of the qubit circuitry 106. For example, the control circuitry 104 may control the performance of a read operation, control the performance of a write operation, control the clearing of quantum bits, etc. The control that the control circuitry 104 may exercise over the operation of its associated qubit circuitry 106 may depend on the type of qubits implemented by the qubit circuitry 106. For example, if the qubit circuitry 106 implements superconducting qubits (discussed below with reference to FIGS. 6-8), the control circuitry 104 may provide and/or detect appropriate electrical signals in any of the flux bias lines, microwave lines, and/or drive lines to initialize and manipulate the superconducting dots. In another example, if the qubit circuitry 106 implements spin qubits (discussed below with reference to FIGS. 8-9), the control circuitry 104 may provide and/or detect appropriate electrical signals in any of the gates 706/708, the quantum well layer 752, the magnet lines 721, etc.

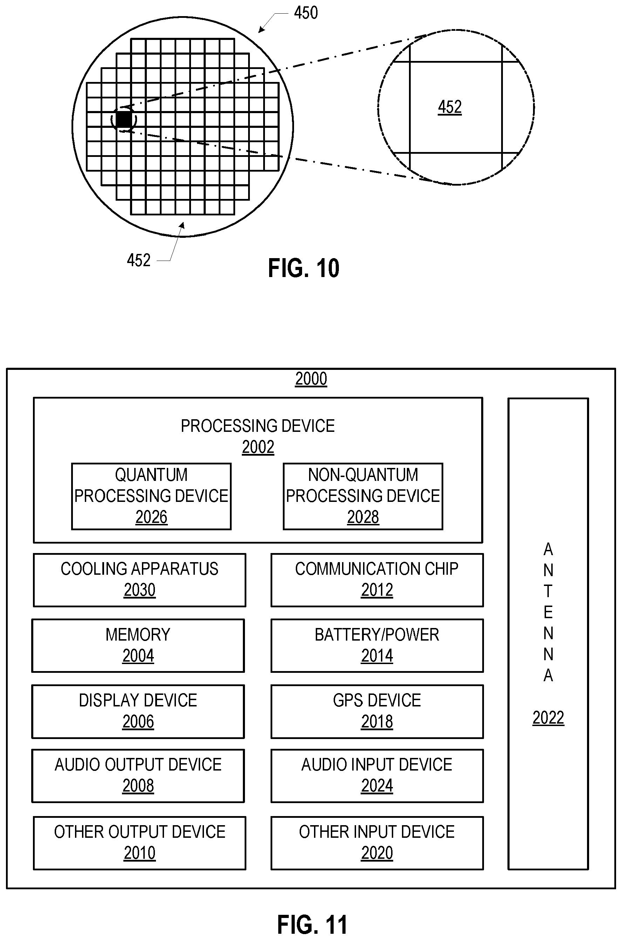

Control circuitry 104 may also perform computing functions to supplement the computing functions that may be provided by the qubit circuitry 106. In particular, the control circuitry 104 of a QC module 128 may interface with external electronic circuitry 108 via one or more optical cables 110 (e.g., fiber-optic cables). Using optical cables 110 to communicate between circuitry inside the refrigerator 102 and circuitry outside the refrigerator 102 may enable higher throughput with less bulk than RF cables, and thus may enable more efficient communication between the refrigerator 102 and the external environment (as well as between refrigerators 102). Further, optical cables 110 introduce less thermal and electromagnetic noise than RF cables. As discussed in further detail below, the control circuitry 104 may include an optical interface 132 configured to transmit and receive optical signals over one or more optical cables to/from external computing circuitry 108. In some embodiments, the control circuitry 104 may include or may be part of the non-quantum processing device 2028 described below with reference to FIG. 11.

As noted above, the qubit circuitry 106 may include one or more qubit dies having qubit elements (e.g., superconducting-type qubit elements and/or spin qubit-type qubit elements, as discussed below). Individual qubit dies may include an insulating material (e.g., a dielectric material formed in multiple layers, as known in the art) and multiple conductive pathways formed through the insulating material. In some embodiments, the insulating material of a qubit die may include a dielectric material, such as silicon dioxide, silicon nitride, oxynitride, polyimide materials, glass reinforced epoxy matrix materials, or a low-k or ultra low-k dielectric (e.g., carbon-doped dielectrics, fluorine-doped dielectrics, porous dielectrics, organic polymeric dielectrics, photoimageable dielectrics, and/or benzocyclobutene-based polymers). In some embodiments, the insulating material of a qubit die may include a semiconductor material, such as silicon, germanium, or a III-V material (e.g., gallium nitride), and one or more additional materials. For example, an insulating material may include silicon oxide or silicon nitride. The conductive pathways in a qubit die may include conductive traces and/or conductive vias, and may connect any of the conductive contacts in the qubit die in any suitable manner (e.g., connecting multiple conductive contacts on a same surface or on different surfaces of the qubit die). The conductive pathways in the qubit die may be bordered by liner materials, such as adhesion liners and/or barrier liners, as suitable.

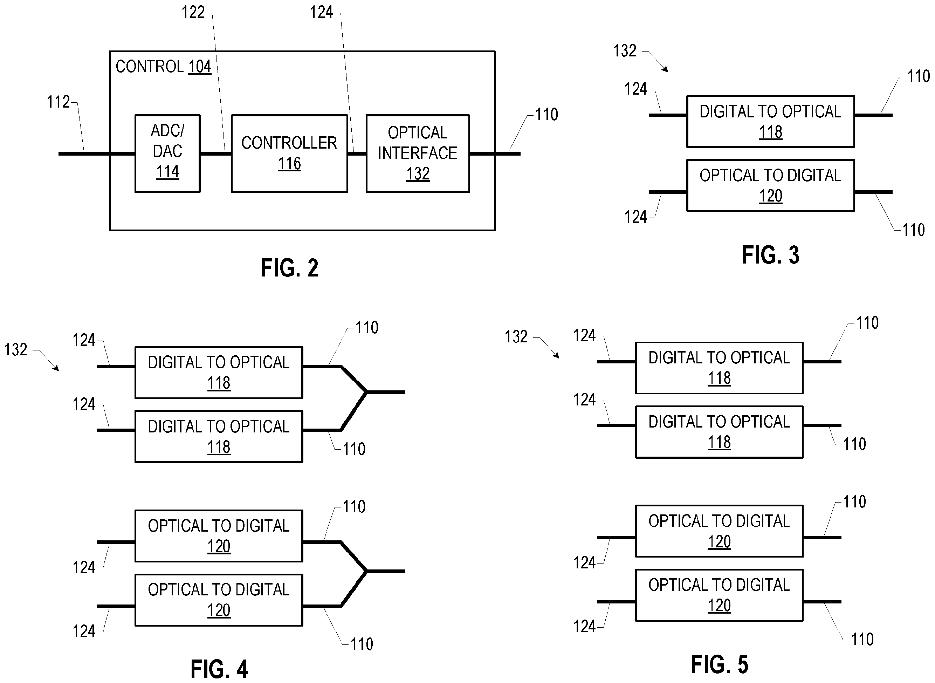

The control circuitry 104 may be located in a warmer part of the refrigerator 102 than the qubit circuitry 106. In particular, the control circuitry 104 may be located in one or more stages N that are warmer than a stage N+M in which the qubit circuitry 106 is located. For example, the control circuitry 104 may be located in a stage of the refrigerator 102 that is maintained at a temperature of 1 kelvin or higher (e.g., maintained at a temperature of 4 kelvin or higher), while the qubit circuitry 106 is located in a stage of the refrigerator that is maintained at a temperature lower than 1 kelvin (e.g., maintained at a temperature of 10 millikelvin or lower). In some embodiments, the control circuitry 104 may be located in a same stage of the refrigerator 102 as the qubit circuitry 106; in some such embodiments, the control circuitry 104 and the qubit circuitry 106 may be implemented in a single circuit board, in a single package, or in a single die. In some embodiments, the control circuitry 104 may be located in a single stage of the refrigerator 102, while in other embodiments, the control circuitry 104 may be distributed across multiple stages of the refrigerator 102. For example, in some embodiments, an optical interface 132 (discussed below with reference to FIGS. 2-5) of the control circuitry 104 may be located in a warmer stage than other elements of the control circuitry 104. Optical cables 110 coupled to the control circuitry 104 may be coupled to optical cables 110 outside of the refrigerator 102 by an optical connector 130, which may provide a thermally insulated optical interface. Any suitable optical connector 130, such as commercially available optical connectors for vacuum applications, may be used.

The control circuitry 104 may communicate with qubit circuitry 106 via communication lines 112. In some embodiments, the communication lines 112 are analog lines, communicating analog signals between the control circuitry 104 and the qubit circuitry 106 (e.g., when the control circuitry 104 includes one or more analog-to-digital converters (ADCs)/digital-to-analog converters(DACs) 114, as discussed below with reference to FIG. 2). In other embodiments, the communication lines 112 may include digital lines, communicating digital signals between the control circuitry 104 and the qubit circuitry 106; such embodiments, however, may also include the use of ADCs/DACs as part of the qubit circuitry 106, and these ADCs/DACs may generate thermal energy that will need to be dissipated by the stage N+M of the refrigerator 102. In other embodiments, the communication lines 112 may include optical lines, communicating optical signals between different ones of the stages of the refrigerator 102.

In FIG. 1, the QC system 100 is depicted as including three refrigerators 102, each with their own associated QC module 128 and each communicating with external electronic circuitry 108 via optical cables 110. The external electronic circuitry 108 may include computing circuitry, other control circuitry, circuitry to interface between multiple refrigerators 102, networking circuitry, or any other suitable circuitry. The particular numbers of refrigerators 102 and QC modules 128, as well as the arrangement of the external electronic circuitry 108 relative to the refrigerators 102, depicted in FIG. 1 is simply illustrative, and other numbers and arrangements may be used. For example, in some embodiments, a QC system 100 may include fewer than three refrigerators 102 or more than four refrigerators 102. In some embodiments, an individual refrigerator 102 may include multiple QC modules 128. In some embodiments, external electronic circuitry 108 may be communicatively coupled between pairs of refrigerators 102/QC modules 128, and different ones of the external electronic circuitry 108 may then be coupled to another set of external electronic circuitry 108 (e.g., in a tree network). These are simply examples, and any suitable variations may be used.

The control circuitry 104 included in a QC module 128 may take any of a number of forms. For example, FIG. 2 is a block diagram of example control circuitry 104 with an optical interface 132, in accordance with various embodiments. As discussed above, the optical interface 132 may control optical transmission and reception between the control circuitry 104 and the external electronic circuitry 108, and may couple to one or more optical cables 110 (e.g., optical cables 110 internal to the associated refrigerator 102, and coupled to optical cables 110 external to the associated refrigerator 102 via an optical connector 130, as discussed above). In some embodiments, the optical interface 132 may control optical transmission and reception between the control circuitry 104 in one refrigerator 102 and the control circuitry 104 in another refrigerator 102 (without significant intervening external electronic circuitry 108). The control circuitry 104 may include one or more controllers 116, which may perform many of the control tasks discussed herein (e.g., the controlling and monitoring of electrical signals provided to the qubit elements of the qubit circuitry 106, the storing of data generated by the qubit circuitry 106, etc.). In some embodiments, a controller 116 may be a digital controller or a mixed-signal controller. The controllers 116 may communicate with one or more ADCs/DACs 114 via one or more digital lines 122, with the DACs converting digital data from controllers 116 via the digital lines 122 into analog data to be transmitted on the communication lines 112, and the ADCs converting analog data from the communication lines 112 into digital data to be transmitted to the controllers 116 via the digital lines 122. Other analog circuitry, such as filters (e.g., low-pass filters), mixers, variable gain amplifiers, and/or power amplifiers, may be included in the control circuitry 104 (not shown). As noted above, in other embodiments, the controllers 116 may output digital data directly to the qubit circuitry 106 (in a colder stage of the refrigerator 102). In some embodiments, the optical interface 132 in the control circuitry 104 may be asymmetric in that a different number of optical cables 110 may be associated with transmit than with receive. Such embodiments may allow the number of optical cables 110 to be matched to the properties of the expected data flow between a QC module 128 and external electronic circuitry 108, avoiding a waste of bandwidth. For example, as efficient QC algorithms may perform hundreds of qubit operations before reading a result, the number of optical cables 110 associated with transmission of data to the external electronic circuitry 108 may be less than the number of optical cables 110 associated with receipt of data from the external electronic circuitry 108.

The optical interface 132 included in the control circuitry 104 may take any of a number of forms. For example, FIGS. 3-5 are block diagrams of example embodiments of portions of an optical interface 132 for control circuitry 104 in a QC system 100, in accordance with various embodiments. In the embodiment of FIG. 3, the optical interface 132 may include a single digital to optical converter (DOC) 118 for providing a single output (i.e., transmit) path from the control circuitry 104 to the external electronic circuitry 108, and a single optical to digital converter (ODC) 120 for providing a single input (i.e., receive) path from the external electronic circuitry 108 to the control circuitry 104. In some embodiments, a DOC 118 may include a laser, such as a micro laser or a nano laser. In some embodiments, a DOC 118 may include a vertical cavity surface emitting laser (VCSEL). An ODC 120 may include a photodetector, such as a semiconductor-based photodiode, and associated amplification circuitry (e.g., a transimpedance amplifier).

In the embodiment of FIG. 4, the optical interface 132 may be configured to multiplex the outputs of multiple DOCs 118 onto a single optical cable 110; analogously, the optical interface 132 may be configured to demultiplex multiple inputs on a single optical cable via multiple ODCs 120. The signals on the optical cable 110 may be multiplexed in any of a number of ways, such as wavelength division multiplexing (WDM) or time division multiplexing (TDM). In the embodiment of FIG. 5, the optical interface may include multiple DOCs 118 for providing multiple outputs to corresponding multiple optical cables 110, and multiple ODCs 120 for providing multiple inputs from corresponding multiple optical cables 110. An optical interface 132 may include an arrangement like any of those illustrated in FIGS. 3-5, and may also include any desired combination of the arrangements of FIGS. 3-5. Further, the particular number of DOCs 118, ODCs 120, optical cables 110, etc. depicted in FIGS. 2-5 is simply illustrative, and an optical interface 132 may include any desired number of these elements. For example, in some embodiments, an optical interface 132 may include a two-dimensional array of DOCs 118 (e.g., semiconductor-based lasers) and/or a two-dimensional array of ODCs 120.

In some embodiments, the control circuitry 104 may implement a direct digital to optical conversion, eliminating or reducing the need for large, expensive, and power-intensive physical layer signal processing circuitry (which are difficult to implement and accommodate cryogenic temperatures). In some such embodiments, data to be transmitted via a DOC 118 may be serialized by a controller 116 (e.g., using pulse amplitude modulation (PAM)) and provided directly to the DOC 118. An example voltage swing that may occur at the output of the controller 116 may be 0 volts (e.g., for a logic zero) and 1.8 volts (e.g., for a logic one), but other voltage ranges may be used. This stream of voltages may be sent directly to the DOC 118 (e.g., a laser, such as a VCSEL), where the DOC 118 performs direct modulation of light (i.e., a logic zero results in no light being emitted and a logic one may result in light being emitted for a specific duration at a wavelength associated with the DOC 118). Direct optical to digital conversion may be performed analogously by the ODC 120, in some embodiments, and may include some amplifier circuitry to condition the signal for the receiving parameters of the controller 116. In some embodiments, such direct conversion processes may be asynchronous in nature in that no clock is sent along with the data and no clock recovery/synchronization sequences are embedded into the data stream for synchronous detection. Instead, a receiver may wait for a start event and then may sample the data at a pre-negotiated interval matching the transmission rate. Error correction methods, such as parity check, word error correction codes, or forward error correction (e.g., turbo codes and low-density parity-check codes) may be implemented by the controller 116 and the external electronic circuitry 108, as desired, for an improved bit-error rate and/or increased data throughput. Direct conversion processes may be used in any of the embodiments of the optical interfaces 132 of FIGS. 3-5 (e.g., with multiple direct conversions happening in parallel in the embodiments of FIGS. 4 and 5). Some embodiments of the control circuitry 104 that implement such direct conversion may achieve a data throughput greater than 1 gigabit per second with a bit-error rate less than 1e-9.

Any of the QC systems 100 disclosed herein may include any suitable circuitry distributed among the elements of the QC system 100. FIGS. 6-9 discuss various examples of QC circuitry that may be distributed among the qubit circuitry 106, control circuitry 104, and/or external electronic circuitry 108 of any of the QC systems 100 disclosed herein. FIGS. 6-8 discuss example embodiments in which the qubit circuitry 106 includes superconducting qubit-type QC circuitry, and FIGS. 8-9 discuss example embodiments in which the qubit circuitry 106 includes spin qubit-type QC circuitry.

The operation of superconducting qubit-type quantum devices may be based on the Josephson effect, a macroscopic quantum phenomenon in which a supercurrent (a current that, due to zero electrical resistance, flows for indefinitely long without any voltage applied) flows across a device known as a Josephson junction. Examples of superconducting qubit-type quantum devices may include charge qubits, flux qubits, and phase qubits. Transmons, a type of charge qubit with the name being an abbreviation of "transmission line shunted plasma oscillation qubits," may exhibit reduced sensitivity to charge noise, and thus may be particularly advantageous. Transmon-type quantum devices may include inductors, capacitors, and at least one nonlinear element (e.g., a Josephson junction) to achieve an effective two-level quantum state system.

Josephson junctions may provide the central circuit elements of a superconducting qubit-type quantum device. A Josephson junction may include two superconductors connected by a weak link. For example, a Josephson junction may be implemented as a thin layer of an insulating material, referred to as a barrier or a tunnel barrier and serving as the "weak link" of the junction, sandwiched between two layers of superconductor. Josephson junctions may act as superconducting tunnel junctions. Cooper pairs may tunnel across the barrier from one superconducting layer to the other. The electrical characteristics of this tunneling are governed by the Josephson relations. Because the inductance of a Josephson junction is nonlinear, when used in an inductor-capacitor circuit (which may be referred to as an LC circuit) in a transmon-type quantum device, the resulting circuit has uneven spacing between its energy states. In other classes of superconducting qubit-type quantum devices, Josephson junctions combined with other circuit elements may similarly provide the nonlinearity necessary for forming an effective two-level quantum state to act as a qubit.

FIG. 6 is a block diagram of an example superconducting quantum circuit 300 that may be included in qubit circuitry 106 of a QC system 100. As shown in FIG. 6, a superconducting quantum circuit 300 includes two or more qubit elements, 302-1 and 302-2. Qubit elements 302-1 and 302-2 may be identical and thus the discussion of FIG. 6 may refer generally to the "qubit elements 302"; the same applies to Josephson junctions 304-1 and 304-2, which may generally be referred to as "Josephson junctions 304," and to circuit elements 306-1 and 306-2, which may generally be referred to as "circuit elements 306." As shown in FIG. 6, each of the superconducting qubit elements 302 may include one or more Josephson junctions 304 connected to one or more other circuit elements 306, which, in combination with the Josephson junction(s) 304, may form a nonlinear circuit providing a unique two-level quantum state for the qubit. The circuit elements 306 could be, for example, capacitors in transmons or superconducting loops in flux qubits.

A superconducting quantum circuit 300 may include circuitry 308 for providing external control of qubit elements 302 and circuitry 310 for providing internal control of qubit elements 302. In this context, "external control" refers to controlling the qubit elements 302 from outside of the die that includes the qubit elements 302, including control by a user of a quantum computer, while "internal control" refers to controlling the qubit elements 302 within the die that includes the qubit elements 302. For example, if qubit elements 302 are transmon qubit elements, external control may be implemented by means of flux bias lines (also known as "flux lines" and "flux coil lines") and by means of readout and drive lines (also known as "microwave lines" since qubit elements are typically designed to operate with microwave signals), described in greater detail below. On the other hand, internal control lines for such qubit elements may be implemented by means of resonators (e.g., coupling and readout resonators, also described in greater detail below).

FIG. 7 illustrates an example of a physical layout 311 of a superconducting quantum circuit where qubit elements are implemented as transmons. Like FIG. 6, FIG. 7 illustrates two qubit elements 302. In addition, FIG. 7 illustrates flux bias lines 312, microwave lines 314, a coupling resonator 316, a readout resonator 318, and conductive contacts 320 and 322. The flux bias lines 312 and the microwave lines 314 may be viewed as examples of the external control circuitry 308 shown in FIG. 6.

Running a current through the flux bias lines 312, provided from the conductive contacts 320, enables the tuning of the frequency of the corresponding qubit elements 302 to which each line 312 is connected. For example, a magnetic field is created by running the current in a particular flux bias line 312. If such a magnetic field is in sufficient proximity to the qubit element 302, the magnetic field couples to the qubit element 302, thereby changing the spacing between the energy levels of the qubit element 302. This, in turn, changes the frequency of the qubit element 302 since the frequency is related to the spacing between the energy levels via Planck's equation. Provided there is sufficient multiplexing, different currents can be sent down each of the flux lines 312, allowing for independent tuning of the various qubit elements 302.

Typically, the qubit frequency may be controlled to bring the frequency either closer to or further away from another resonant element, such as a coupling resonator 316 as shown in FIG. 7 that connects two or more qubit elements 302 together. For example, if it is desired that a first qubit element 302 (e.g. the qubit element 302 shown on the left side of FIG. 7) and a second qubit element 302 (e.g. the qubit element 302 shown on the right side of FIG. 7) interact, via the coupling resonator 316 connecting these qubit elements, then both qubit elements 302 may be tuned at nearly the same frequency. In other scenarios, two qubit elements 302 could interact via a coupling resonator 316 at specific frequencies, but these three elements do not have to be tuned to be at nearly the same frequency with one another. Interactions between the qubit elements 302 can similarly be reduced or prevented by controlling the current in the appropriate flux bias lines. The state(s) of each qubit element 302 may be read by way of its corresponding readout resonator 318. As discussed below, the qubit element 302 may induce a resonant frequency in the readout resonator 318. This resonant frequency is then passed to the microwave lines 314 and communicated to the conductive contacts 322.

A readout resonator 318 may be provided for each qubit element. The readout resonator 318 may be a transmission line that includes a capacitive connection to ground on one side and is either shorted to ground on the other side (for a quarter-wavelength resonator) or has a capacitive connection to ground (for a half-wavelength resonator), which results in oscillations within the transmission line (resonance). The resonant frequency of the oscillations may be close to the frequency of the qubit element 302. The readout resonator 318 may be coupled to the qubit element 302 by being in sufficient proximity to the qubit element 302 (e.g., through capacitive or inductive coupling). Due to the coupling between the readout resonator 318 and the qubit element 302, changes in the state of the qubit element 302 may result in changes of the resonant frequency of the readout resonator 318. In turn, because the readout resonator 318 is in sufficient proximity to the microwave line 314, changes in the resonant frequency of the readout resonator 318 may induce changes in the current in the microwave line 314, and that current can be read externally via the conductive contacts 322.

The coupling resonator 316 may be used to couple different qubit elements together to realize quantum logic gates. The coupling resonator 316 may be similar to the readout resonator 318 in that it is a transmission line that may include capacitive connections to ground on both sides (for a half-wavelength resonator), which may result in oscillations within the coupling resonator 316. Each side of the coupling resonator 316 may be coupled (again, either capacitively or inductively) to a respective qubit element 302 by being in sufficient proximity to the qubit element 302. Because each side of the coupling resonator 316 couples with a respective different qubit element 302, the two qubit elements 302 may be coupled together through the coupling resonator 316. In this manner, a state of one qubit element 302 may depend on the state of the other qubit element 302, and vice versa. Thus, coupling resonators 316 may be employed to use a state of one qubit element 302 to control a state of another qubit element 302.

In some implementations, the microwave line 314 may be used to not only readout the state of the qubit elements 302 as described above, but also to control the state of the qubit elements 302. When a single microwave line 314 is used for this purpose, the line 314 may operate in a half-duplex mode in which, at some times, it is configured to readout the state of the qubit elements 302, and, at other times, it is configured to control the state of the qubit elements 302. In other implementations, microwave lines such as the line 314 shown in FIG. 7 may be used to only readout the state of the qubit elements as described above, while separate drive lines (such as the drive lines 324 shown in FIG. 7) may be used to control the state of the qubit elements 302. In such implementations, the microwave lines used for readout may be referred to as readout lines (e.g., the readout line 314), while microwave lines used for controlling the state of the qubit elements may be referred to as drive lines (e.g., the drive lines 324). The drive lines 324 may control the state of their respective qubit elements 302 by providing (e.g., using conductive contacts 326 as shown in FIG. 7) a microwave pulse at the qubit frequency, which in turn stimulates a transition between the states of the qubit element 302. By varying the length of this pulse, a partial transition can be stimulated, giving a superposition of the states of the qubit element 302.

Flux bias lines, microwave lines, coupling resonators, drive lines, and readout resonators, such as those described above, together form interconnects for supporting propagation of microwave signals. Further, any other connections for providing direct electrical interconnection between different quantum circuit elements and components, such as connections from Josephson junction electrodes to capacitor plates or to superconducting loops of superconducting quantum interference devices (SQUIDS) or connections between two ground lines of a particular transmission line for equalizing electrostatic potential on the two ground lines, are also referred to herein as interconnects. Electrical interconnections may also be provided between quantum circuit elements and components and non-quantum circuit elements, which may also be provided in a quantum circuit, as well as to electrical interconnections between various non-quantum circuit elements provided in a quantum circuit. Examples of non-quantum circuit elements that may be provided in a quantum circuit may include various analog and/or digital systems, e.g. ADCs, mixers, multiplexers, amplifiers, etc. In some embodiments, these non-quantum elements may be included in the control circuitry 104.

Coupling resonators and readout resonators may be configured for capacitive coupling to other circuit elements at one or both ends to have resonant oscillations, whereas flux bias lines and microwave lines may be similar to conventional microwave transmission lines because there is no resonance in these lines. Each one of these interconnects may be implemented as any suitable architecture of a microwave transmission line, such as a coplanar waveguide, a stripline, a microstrip line, or an inverted microstrip line. Typical materials that may be included in the interconnects may include aluminum, niobium, niobium nitride, titanium nitride, molybdenum rhenium, and niobium titanium nitride, all of which are particular types of superconductors. However, in various embodiments, other suitable superconductors and alloys of superconductors may be used as well.

In various embodiments, the interconnects as shown in FIG. 7 could have different shapes and layouts. For example, some interconnects may comprise more curves and turns while other interconnects may comprise fewer curves and turns, and some interconnects may comprise substantially straight lines. In some embodiments, various interconnects may intersect one another, in such a manner that they don't make an electrical connection, which can be done by using a bridge to bridge one interconnect over the other, for example.

In addition, FIG. 7 further illustrates ground contacts 328, connecting to the ground plane. Such ground contacts 328 may be used when a die supports propagation of microwave signals to suppress microwave parallel plate modes, cross-coupling between circuit blocks, and/or substrate resonant modes. In general, providing ground pathways may improve signal quality, enable fast pulse excitation, and improve the isolation between the different lines.

Only two ground contacts are labeled in FIG. 7 with the reference numeral 328, but all white circles shown throughout FIG. 7 may illustrate exemplary locations of ground conductive contacts. The illustration of the location and the number of the ground contacts 328 in FIG. 7 is purely illustrative and, in various embodiments, ground contacts 328 may be provided at different places, as known in microwave engineering. More generally, any number of qubit elements 302, flux bias lines 312, microwave lines 314, coupling resonators 316, readout resonators 318, drive lines 324, contacts 320, 322, 326, and 328, and other components discussed herein with reference to the superconducting quantum circuit 300 may be included in a QC module 128.

While FIGS. 6 and 7 depict examples of quantum circuits comprising only two qubit elements 302, this is simply illustrative, and embodiments with any larger number of qubit elements are within the scope of the present disclosure. Furthermore, while FIGS. 6 and 7 may illustrate various features specific to transmon-type quantum devices, the QC systems 100 disclosed herein may include quantum circuits implementing other types of superconducting qubit elements.

As noted above, in some embodiments, a QC module 128 may include spin qubit-type quantum devices in the qubit circuitry 106. FIG. 8 depicts cross-sectional views of an example spin qubit-type quantum device 700, in accordance with various embodiments. In particular, FIG. 8B illustrates the spin qubit-type quantum device 700 taken along the section A-A of FIG. 8A (while FIG. 8A illustrates the spin qubit-type quantum device 700 taken along the section C-C of FIG. 8B), and FIG. 8C illustrates the spin qubit-type quantum device 700 taken along the section B-B of FIG. 8A with a number of components not shown to more readily illustrate how the gates 706/708 and the magnet line 721 may be patterned (while FIG. 8A illustrates a spin qubit-type quantum device 700 taken along the section D-D of FIG. 8C). Although FIG. 8A indicates that the cross-section illustrated in FIG. 8B is taken through the fin 704-1, an analogous cross-section taken through the fin 704-2 may be identical, and thus the discussion of FIG. 8B refers generally to the "fin 704." The spin qubit-type quantum device 700 is simply illustrative, and other spin qubit-type quantum devices may be included in a QC system 100.

The spin qubit-type quantum device 700 may include a base 702 and multiple fins 704 extending away from the base 702. The base 702 and the fins 704 may include a substrate and a quantum well stack (not shown in FIG. 8, but discussed below with reference to the substrate 744 and the quantum well stack 746), distributed in any of a number of ways between the base 702 and the fins 704. The base 702 may include at least some of the substrate, and the fins 704 may each include a quantum well layer of the quantum well stack (discussed below with reference to the quantum well layer 752).

Although only two fins, 704-1 and 704-2, are shown in FIG. 8, this is simply for ease of illustration, and more than two fins 704 may be included in the spin qubit-type quantum device 700. In some embodiments, the total number of fins 704 included in the spin qubit-type quantum device 700 is an even number, with the fins 704 organized into pairs including one active fin 704 and one read fin 704, as discussed in detail below. When the spin qubit-type quantum device 700 includes more than two fins 704, the fins 704 may be arranged in pairs in a line (e.g., 2N fins total may be arranged in a 1x2N line, or a 2xN line) or in pairs in a larger array (e.g., 2N fins total may be arranged as a 4xN/2 array, a 6xN/3 array, etc.). The discussion herein will largely focus on a single pair of fins 704 for ease of illustration, but all the teachings of the present disclosure apply to spin qubit-type quantum devices 700 with more fins 704.

As noted above, each of the fins 704 may include a quantum well layer (not shown in FIG. 8, but discussed below with reference to the quantum well layer 752). The quantum well layer included in the fins 704 may be arranged normal to the z-direction, and may provide a layer in which a two-dimensional electron gas (2DEG) may form to enable the generation of a quantum dot during operation of the spin qubit-type quantum device 700, as discussed in further detail below. The quantum well layer itself may provide a geometric constraint on the z-location of quantum dots in the fins 704, and the limited extent of the fins 704 (and therefore the quantum well layer) in the y-direction may provide a geometric constraint on the y-location of quantum dots in the fins 704. To control the x-location of quantum dots in the fins 704, voltages may be applied to gates disposed on the fins 704 to adjust the energy profile along the fins 704 in the x-direction and thereby constrain the x-location of quantum dots within quantum wells (discussed in detail below with reference to the gates 706/708). The dimensions of the fins 704 may take any suitable values. For example, in some embodiments, the fins 704 may each have a width 762 between 10 nanometers and 30 nanometers. In some embodiments, the fins 704 may each have a height 764 between 200 nanometers and 400 nanometers (e.g., between 250 nanometers and 350 nanometers, or equal to 300 nanometers).

The fins 704 may be arranged in parallel, as illustrated in FIGS. 8A and 8C, and may be spaced apart by an insulating material 728, which may be disposed on opposite faces of the fins 704. The insulating material 728 may be a dielectric material, such as silicon oxide. For example, in some embodiments, the fins 704 may be spaced apart by a distance 760 between 100 nanometers and 250 nanometers.

Multiple gates may be disposed on each of the fins 704. In the embodiment illustrated in FIG. 8B, three gates 706 and two gates 708 are shown as distributed on the top of the fin 704. This particular number of gates is simply illustrative, and any suitable number of gates may be used.

As shown in FIG. 8B, the gate 708-1 may be disposed between the gates 706-1 and 706-2, and the gate 708-2 may be disposed between the gates 706-2 and 706-3. Each of the gates 706/708 may include a gate dielectric 714; in the embodiment illustrated in FIG. 8B, the gate dielectric 714 for all the gates 706/708 is provided by a common layer of gate dielectric material. In other embodiments, the gate dielectric 714 for each of the gates 706/708 may be provided by separate portions of gate dielectric 714. In some embodiments, the gate dielectric 714 may be a multilayer gate dielectric (e.g., with multiple materials used to improve the interface between the fin 704 and the corresponding gate metal). The gate dielectric 714 may be, for example, silicon oxide, aluminum oxide, or a high-k dielectric, such as hafnium oxide. More generally, the gate dielectric 714 may include elements such as hafnium, silicon, oxygen, titanium, tantalum, lanthanum, aluminum, zirconium, barium, strontium, yttrium, lead, scandium, niobium, and zinc. Examples of materials that may be used in the gate dielectric 714 may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In some embodiments, an annealing process may be carried out on the gate dielectric 714 to improve the quality of the gate dielectric 714.

Each of the gates 706 may include a gate metal 710 and a hardmask 716. The hardmask 716 may be formed of silicon nitride, silicon carbide, or another suitable material. The gate metal 710 may be disposed between the hardmask 716 and the gate dielectric 714, and the gate dielectric 714 may be disposed between the gate metal 710 and the fin 704. Only one portion of the hardmask 716 is labeled in FIG. 8B for ease of illustration. In some embodiments, the gate metal 710 may be a superconductor, such as aluminum, titanium nitride (e.g., deposited via atomic layer deposition (ALD)), or niobium titanium nitride. In some embodiments, the hardmask 716 may not be present in the spin qubit-type quantum device 700 (e.g., a hardmask like the hardmask 716 may be removed during processing, as discussed below). The sides of the gate metal 710 may be substantially parallel, as shown in FIG. 8B, and insulating spacers 734 may be disposed on the sides of the gate metal 710 and the hardmask 716. As illustrated in FIG. 8B, the spacers 734 may be thicker closer to the fin 704 and thinner farther away from the fin 704. In some embodiments, the spacers 734 may have a convex shape. The spacers 734 may be formed of any suitable material, such as a carbon-doped oxide, silicon nitride, silicon oxide, or other carbides or nitrides (e.g., silicon carbide, silicon nitride doped with carbon, and silicon oxynitride). The gate metal 710 may be any suitable metal, such as titanium nitride.

Each of the gates 708 may include a gate metal 712 and a hardmask 718. The hardmask 718 may be formed of silicon nitride, silicon carbide, or another suitable material. The gate metal 712 may be disposed between the hardmask 718 and the gate dielectric 714, and the gate dielectric 714 may be disposed between the gate metal 712 and the fin 704. In the embodiment illustrated in FIG. 8B, the hardmask 718 may extend over the hardmask 716 (and over the gate metal 710 of the gates 706), while in other embodiments, the hardmask 718 may not extend over the gate metal 710. In some embodiments, the gate metal 712 may be a different metal from the gate metal 710; in other embodiments, the gate metal 712 and the gate metal 710 may have the same material composition. In some embodiments, the gate metal 712 may be a superconductor, such as aluminum, titanium nitride (e.g., deposited via ALD), or niobium titanium nitride. In some embodiments, the hardmask 718 may not be present in the spin qubit-type quantum device 700 (e.g., a hardmask like the hardmask 718 may be removed during processing, as discussed below).

The gate 708-1 may extend between the proximate spacers 734 on the sides of the gate 706-1 and the gate 706-2, as shown in FIG. 8B. In some embodiments, the gate metal 712 of the gate 708-1 may extend between the spacers 734 on the sides of the gate 706-1 and the gate 706-2. Thus, the gate metal 712 of the gate 708-1 may have a shape that is substantially complementary to the shape of the spacers 734, as shown. Similarly, the gate 708-2 may extend between the proximate spacers 734 on the sides of the gate 706-2 and the gate 706-3. In some embodiments in which the gate dielectric 714 is not a layer shared commonly between the gates 708 and 706, but instead is separately deposited on the fin 704 between the spacers 734, the gate dielectric 714 may extend at least partially up the sides of the spacers 734, and the gate metal 712 may extend between the portions of gate dielectric 714 on the spacers 734. The gate metal 712, like the gate metal 710, may be any suitable metal, such as titanium nitride.

The dimensions of the gates 706/708 may take any suitable values. For example, in some embodiments, the z-height 766 of the gate metal 710 may be between 40 nanometers and 75 nanometers (e.g., approximately 50 nanometers); the z-height of the gate metal 712 may be in the same range. In embodiments like the ones illustrated in FIG. 8B, the z-height of the gate metal 712 may be greater than the z-height of the gate metal 710. In some embodiments, the length 768 of the gate metal 710 (i.e., in the x-direction) may be between 20 nanometers and 40 nanometers (e.g., 30 nanometers). In some embodiments, the distance 770 between adjacent ones of the gates 706 (e.g., as measured from the gate metal 710 of one gate 706 to the gate metal 710 of an adjacent gate 706 in the x-direction, as illustrated in FIG. 8B), may be between 40 nanometers and 60 nanometers (e.g., 50 nanometers). In some embodiments, the thickness 772 of the spacers 734 may be between 1 nanometer and 10 nanometers (e.g., between 3 nanometers and 5 nanometers, between 4 nanometers and 6 nanometers, or between 4 nanometers and 7 nanometers). The length of the gate metal 712 (i.e., in the x-direction) may depend on the dimensions of the gates 706 and the spacers 734, as illustrated in FIG. 8B. As indicated in FIG. 8A, the gates 706/708 on one fin 704 may extend over the insulating material 728 beyond their respective fins 704 and towards the other fin 704, but may be isolated from their counterpart gates by the intervening insulating material 730 and spacers 734.

Although all the gates 706 are illustrated in the accompanying drawings as having the same length 768 of the gate metal 710, in some embodiments, the "outermost" gates 706 (e.g., the gates 706-1 and 706-3 of the embodiment illustrated in FIG. 8B) may have a greater length 768 than the "inner" gates 706 (e.g., the gate 706-2 in the embodiment illustrated in FIG. 8B). Such longer "outside" gates 706 may provide spatial separation between the doped regions 740 and the areas under the gates 708 and the inner gates 706 in which quantum dots 742 may form, and thus may reduce the perturbations to the potential energy landscape under the gates 708 and the inner gates 706 caused by the doped regions 740.

As shown in FIG. 8B, the gates 706 and 708 may be alternatingly arranged along the fin 704 in the x-direction. During operation of the spin qubit-type quantum device 700, voltages may be applied to the gates 706/708 to adjust the potential energy in the quantum well layer (not shown) in the fin 704 to create quantum wells of varying depths in which quantum dots 742 may form. Only one quantum dot 742 is labeled with a reference numeral in FIGS. 8B and 8C for ease of illustration, but five are indicated as dotted circles in each fin 704. The location of the quantum dots 742 in FIG. 8B is not intended to indicate a particular geometric positioning of the quantum dots 742. The spacers 734 may themselves provide "passive" barriers between quantum wells under the gates 706/708 in the quantum well layer, and the voltages applied to different ones of the gates 706/708 may adjust the potential energy under the gates 706/708 in the quantum well layer; decreasing the potential energy may form quantum wells, while increasing the potential energy may form quantum barriers. A gate 706/708 and the portion of the quantum well layer under that gate may serve as a qubit element in spin qubit-type devices.

The fins 704 may include doped regions 740 that may serve as a reservoir of charge carriers for the spin qubit-type quantum device 700. For example, an n-type doped region 740 may supply electrons for electron-type quantum dots 742, and a p-type doped region 740 may supply holes for hole-type quantum dots 742. In some embodiments, an interface material 741 may be disposed at a surface of a doped region 740, as shown. The interface material 741 may facilitate electrical coupling between a conductive contact (e.g., a via 736, as discussed below) and the doped region 740. The interface material 741 may be any suitable metal-semiconductor ohmic contact material; for example, in embodiments in which the doped region 740 includes silicon, the interface material 741 may include nickel silicide, aluminum silicide, titanium silicide, molybdenum silicide, cobalt silicide, tungsten silicide, or platinum silicide. In some embodiments, the interface material 741 may be a non-silicide compound, such as titanium nitride. In some embodiments, the interface material 741 may be a metal (e.g., aluminum, tungsten, or indium).

The spin qubit-type quantum devices 700 disclosed herein may be used to form electron-type or hole-type quantum dots 742. Note that the polarity of the voltages applied to the gates 706/708 to form quantum wells/barriers depends on the charge carriers used in the spin qubit-type quantum device 700. In embodiments in which the charge carriers are electrons (and thus the quantum dots 742 are electron-type quantum dots), amply negative voltages applied to a gate 706/708 may increase the potential barrier under the gate 706/708, and amply positive voltages applied to a gate 706/708 may decrease the potential barrier under the gate 706/708 (thereby forming a potential well in which an electron-type quantum dot 742 may form). In embodiments in which the charge carriers are holes (and thus the quantum dots 742 are hole-type quantum dots), amply positive voltages applied to a gate 706/708 may increase the potential barrier under the gate 706/708, and amply negative voltages applied to a gate 706/708 may decrease the potential barrier under the gate 706/708 (thereby forming a potential well in which a hole-type quantum dot 742 may form). The spin qubit-type quantum devices 700 disclosed herein may be used to form electron-type or hole-type quantum dots.

Voltages may be applied to each of the gates 706 and 708 separately to adjust the potential energy in the quantum well layer under the gates 706 and 708, and thereby control the formation of quantum dots 742 under each of the gates 706 and 708. Additionally, the relative potential energy profiles under different ones of the gates 706 and 708 allow the spin qubit-type quantum device 700 to tune the potential interaction between quantum dots 742 under adjacent gates. For example, if two adjacent quantum dots 742 (e.g., one quantum dot 742 under a gate 706 and another quantum dot 742 under a gate 708) are separated by only a short potential barrier, the two quantum dots 742 may interact more strongly than if they were separated by a taller potential barrier. Since the depth of the potential wells/height of the potential barriers under each gate 706/708 may be adjusted by adjusting the voltages on the respective gates 706/708, the differences in potential between adjacent gates 706/708 may be adjusted, and thus the interaction tuned.

In some applications, the gates 708 may be used as plunger gates to enable the formation of quantum dots 742 under the gates 708, while the gates 706 may be used as barrier gates to adjust the potential barrier between quantum dots 742 formed under adjacent gates 708. In other applications, the gates 708 may be used as barrier gates, while the gates 706 are used as plunger gates. In other applications, quantum dots 742 may be formed under all the gates 706 and 708, or under any desired subset of the gates 706 and 708.

Vias and lines may contact the gates 706/708 and the doped regions 740 to enable electrical connection to the gates 706/708 and the doped regions 740 to be made in desired locations. As shown in FIG. 8, the gates 706 may extend away from the fins 704, and vias 720 may contact the gates 706 (and are drawn in dashed lines in FIG. 8B to indicate their location behind the plane of the drawing). The vias 720 may extend through the hardmask 716 and the hardmask 718 to contact the gate metal 710 of the gates 706. The gates 708 may extend away from the fins 704, and the vias 722 may contact the gates 708 (also drawn in dashed lines in FIG. 8B to indicate their location behind the plane of the drawing). The vias 722 may extend through the hardmask 718 to contact the gate metal 712 of the gates 708. Vias 736 may contact the interface material 741 and may thereby make electrical contact with the doped regions 740. The spin qubit-type quantum device 700 may include further vias and/or lines (not shown) to make electrical contact to the gates 706/708 and/or the doped regions 740, as desired. The vias and lines included in a spin qubit-type quantum device 700 may include any suitable materials, such as copper, tungsten (deposited, e.g., by chemical vapor deposition (CVD)), or a superconductor (e.g., aluminum, tin, titanium nitride, niobium titanium nitride, tantalum, niobium, or other niobium compounds such as niobium tin and niobium germanium).

During operation, a bias voltage may be applied to the doped regions 740 (e.g., via the vias 736 and the interface material 741) to cause current to flow through the doped regions 740. When the doped regions 740 are doped with an n-type material, this voltage may be positive; when the doped regions 740 are doped with a p-type material, this voltage may be negative. The magnitude of this bias voltage may take any suitable value (e.g., between 0.25 volts and 2 volts).

The spin qubit-type quantum device 700 may include one or more magnet lines 721. For example, a single magnet line 721 is illustrated in FIG. 8 proximate to the fin 704-1. The magnet line 721 may be formed of a conductive material, and may be used to conduct current pulses that generate magnetic fields to influence the spin states of one or more of the quantum dots 742 that may form in the fins 704. In some embodiments, the magnet line 721 may conduct a pulse to reset (or "scramble") nuclear and/or quantum dot spins. In some embodiments, the magnet line 721 may conduct a pulse to initialize an electron in a quantum dot in a particular spin state. In some embodiments, the magnet line 721 may conduct current to provide a continuous, oscillating magnetic field to which the spin of a qubit may couple. The magnet line 721 may provide any suitable combination of these embodiments, or any other appropriate functionality.

In some embodiments, the magnet line 721 may be formed of copper. In some embodiments, the magnet line 721 may be formed of a superconductor, such as aluminum. The magnet line 721 illustrated in FIG. 8 is non-coplanar with the fins 704, and is also non-coplanar with the gates 706/708. In some embodiments, the magnet line 721 may be spaced apart from the gates 706/708 by a distance 767. The distance 767 may take any suitable value (e.g., based on the desired strength of the magnetic field interaction with the quantum dots 742); in some embodiments, the distance 767 may be between 25 nanometers and 1 micron (e.g., between 50 nanometers and 200 nanometers).

In some embodiments, the magnet line 721 may be formed of a magnetic material. For example, a magnetic material (such as cobalt) may be deposited in a trench in the insulating material 730 to provide a permanent magnetic field in the spin qubit-type quantum device 700.

The magnet line 721 may have any suitable dimensions. For example, the magnet line 721 may have a thickness 769 between 25 nanometers and 100 nanometers. The magnet line 721 may have a width 771 between 25 nanometers and 100 nanometers. In some embodiments, the width 771 and thickness 769 of a magnet line 721 may be equal to the width and thickness, respectively, of other conductive pads in the spin qubit-type quantum device 700 (not shown) used to provide electrical interconnects, as known in the art. The magnet line 721 may have a length 773 that may depend on the number and dimensions of the gates 706/708 that are to form quantum dots 742 with which the magnet line 721 is to interact. The magnet line 721 illustrated in FIG. 8 is substantially linear, but this need not be the case; the magnet lines 721 disclosed herein may take any suitable shape. Vias 723 may contact the magnet line 721.

The vias 720, 722, 736, and 723 may be electrically isolated from each other by an insulating material 730. The insulating material 730 may be any suitable material, such as an interlayer dielectric (ILD). Examples of the insulating material 730 may include silicon oxide, silicon nitride, aluminum oxide, carbon-doped oxide, and/or silicon oxynitride. As known in the art of integrated circuit manufacturing, vias and lines may be formed in an iterative process in which layers of structures are formed on top of each other. In some embodiments, the vias 720/722/736/723 may have a width that is 20 nanometers or greater at their widest point (e.g., 30 nanometers), and a pitch of 80 nanometers or greater (e.g., 100 nanometers). In some embodiments, conductive pads (not shown) included in the spin qubit-type quantum device 700 may have a width that is 100 nanometers or greater, and a pitch of 100 nanometers or greater. The particular arrangement of vias shown in FIG. 8 is simply illustrative, and any electrical routing arrangement may be implemented.

As discussed above, the structure of the fin 704-1 may be the same as the structure of the fin 704-2; similarly, the construction of gates 706/708 on the fin 704-1 may be the same as the construction of gates 706/708 on the fin 704-2. The gates 706/708 on the fin 704-1 may be mirrored by corresponding gates 706/708 on the parallel fin 704-2, and the insulating material 730 may separate the gates 706/708 on the different fins 704-1 and 704-2. In particular, quantum dots 742 formed in the fin 704-1 (under the gates 706/708) may have counterpart quantum dots 742 in the fin 704-2 (under the corresponding gates 706/708). In some embodiments, the quantum dots 742 in the fin 704-1 may be used as "active" quantum dots in the sense that these quantum dots 742 act as qubits and are controlled (e.g., by voltages applied to the gates 706/708 of the fin 704-1) to perform quantum computations. The quantum dots 742 in the fin 704-2 may be used as "read" quantum dots in the sense that these quantum dots 742 may sense the quantum state of the quantum dots 742 in the fin 704-1 by detecting the electric field generated by the charge in the quantum dots 742 in the fin 704-1, and may convert the quantum state of the quantum dots 742 in the fin 704-1 into electrical signals that may be detected by the gates 706/708 on the fin 704-2. Each quantum dot 742 in the fin 704-1 may be read by its corresponding quantum dot 742 in the fin 704-2. Thus, the spin qubit-type quantum device 700 enables both quantum computation and the ability to read the results of a quantum computation.

As discussed above, the base 702 and the fin 704 of a spin qubit-type quantum device 700 may be formed from a substrate 744 and a quantum well stack 746 disposed on the substrate 744. The quantum well stack 746 may include a quantum well layer in which a 2DEG may form during operation of the spin qubit-type quantum device 700. The quantum well stack 746 may take any of a number of forms, several of which are illustrated in FIG. 9. The various layers in the quantum well stacks 746 discussed below may be grown on the substrate 744 (e.g., using epitaxial processes).

FIG. 9A is a cross-sectional view of a quantum well stack 746 including only a quantum well layer 752. The quantum well layer 752 may be disposed on the substrate 744, and may be formed of a material such that, during operation of the spin qubit-type quantum device 700, a 2DEG may form in the quantum well layer 752 proximate to the upper surface of the quantum well layer 752. The gate dielectric 714 of the gates 706/708 may be disposed on the upper surface of the quantum well layer 752. In some embodiments, the quantum well layer 752 of FIG. 9A may be formed of intrinsic silicon, and the gate dielectric 714 may be formed of silicon oxide; in such an arrangement, during use of the spin qubit-type quantum device 700, a 2DEG may form in the intrinsic silicon at the interface between the intrinsic silicon and the silicon oxide. Embodiments in which the quantum well layer 752 of FIG. 9A is formed of intrinsic silicon may be particularly advantageous for electron-type spin qubit-type quantum devices 700. In some embodiments, the quantum well layer 752 of FIG. 9A may be formed of intrinsic germanium, and the gate dielectric 714 may be formed of germanium oxide; in such an arrangement, during use of the spin qubit-type quantum device 700, a 2DEG may form in the intrinsic germanium at the interface between the intrinsic germanium and the germanium oxide. Such embodiments may be particularly advantageous for hole-type spin qubit-type quantum devices 700. In some embodiments, the quantum well layer 752 may be strained, while in other embodiments, the quantum well layer 752 may not be strained. The thicknesses (i.e., z-heights) of the layers in the quantum well stack 746 of FIG. 9A may take any suitable values. For example, in some embodiments, the thickness of the quantum well layer 752 (e.g., intrinsic silicon or germanium) may be between 0.8 microns and 1.2 microns.

FIG. 9B is a cross-sectional view of a quantum well stack 746 including a quantum well layer 752 and a barrier layer 754. The quantum well stack 746 may be disposed on a substrate 744 such that the barrier layer 754 is disposed between the quantum well layer 752 and the substrate 744. The barrier layer 754 may provide a potential barrier between the quantum well layer 752 and the substrate 744. As discussed above, the quantum well layer 752 of FIG. 9B may be formed of a material such that, during operation of the spin qubit-type quantum device 700, a 2DEG may form in the quantum well layer 752 proximate to the upper surface of the quantum well layer 752. For example, in some embodiments in which the substrate 744 is formed of silicon, the quantum well layer 752 of FIG. 9B may be formed of silicon, and the barrier layer 754 may be formed of silicon germanium. The germanium content of this silicon germanium may be 20-80 atomic-% (e.g., 30 atomic-%). In some embodiments in which the quantum well layer 752 is formed of germanium, the barrier layer 754 may be formed of silicon germanium (with a germanium content of 20-80 atomic-% (e.g., 70 atomic-%)). The thicknesses (i.e., z-heights) of the layers in the quantum well stack 746 of FIG. 9B may take any suitable values. For example, in some embodiments, the thickness of the barrier layer 754 (e.g., silicon germanium) may be between 0 nanometers and 400 nanometers. In some embodiments, the thickness of the quantum well layer 752 (e.g., silicon or germanium) may be between 5 nanometers and 30 nanometers.

FIG. 9C is a cross-sectional view of a quantum well stack 746 including a quantum well layer 752 and a barrier layer 754-1, as well as a buffer layer 776 and an additional barrier layer 754-2. The quantum well stack 746 may be disposed on the substrate 744 such that the buffer layer 776 is disposed between the barrier layer 754-1 and the substrate 744. The buffer layer 776 may be formed of the same material as the barrier layer 754, and may be present to trap defects that form in this material as it is grown on the substrate 744. In some embodiments, the buffer layer 776 may be grown under different conditions (e.g., deposition temperature or growth rate) from the barrier layer 754-1. In particular, the barrier layer 754-1 may be grown under conditions that achieve fewer defects than the buffer layer 776. In some embodiments in which the buffer layer 776 includes silicon germanium, the silicon germanium of the buffer layer 776 may have a germanium content that varies from the substrate 744 to the barrier layer 754-1; for example, the silicon germanium of the buffer layer 776 may have a germanium content that varies from zero percent at the silicon substrate 744 to a nonzero percent (e.g., 30%) at the barrier layer 754-1. The thicknesses (i.e., z-heights) of the layers in the quantum well stack 746 of FIG. 9C may take any suitable values. For example, in some embodiments, the thickness of the buffer layer 776 (e.g., silicon germanium) may be between 0.3 microns and 4 microns (e.g., 0.3 microns to 2 microns, or 0.5 microns). In some embodiments, the thickness of the barrier layer 754-1 (e.g., silicon germanium) may be between 0 nanometers and 400 nanometers. In some embodiments, the thickness of the quantum well layer 752 (e.g., silicon or germanium) may be between 5 nanometers and 30 nanometers (e.g., 10 nanometers). The barrier layer 754-2, like the barrier layer 754-1, may provide a potential energy barrier around the quantum well layer 752, and may take the form of any of the embodiments of the barrier layer 754-1. In some embodiments, the thickness of the barrier layer 754-2 (e.g., silicon germanium) may be between 25 nanometers and 75 nanometers (e.g., 32 nanometers).

As discussed above with reference to FIG. 9B, the quantum well layer 752 of FIG. 9C may be formed of a material such that, during operation of the spin qubit-type quantum device 700, a 2DEG may form in the quantum well layer 752 proximate to the upper surface of the quantum well layer 752. For example, in some embodiments in which the substrate 744 is formed of silicon, the quantum well layer 752 of FIG. 9C may be formed of silicon, and the barrier layer 754-1 and the buffer layer 776 may be formed of silicon germanium. In some such embodiments, the silicon germanium of the buffer layer 776 may have a germanium content that varies from the substrate 744 to the barrier layer 754-1; for example, the silicon germanium of the buffer layer 776 may have a germanium content that varies from zero percent at the silicon substrate 744 to a nonzero percent (e.g., 30%) at the barrier layer 754-1. In other embodiments, the buffer layer 776 may have a germanium content equal to the germanium content of the barrier layer 754-1 but may be thicker than the barrier layer 754-1 to absorb the defects that arise during growth.

In some embodiments, the quantum well layer 752 of FIG. 9C may be formed of germanium, and the buffer layer 776 and the barrier layer 754-1 may be formed of silicon germanium. In some such embodiments, the silicon germanium of the buffer layer 776 may have a germanium content that varies from the substrate 744 to the barrier layer 754-1; for example, the silicon germanium of the buffer layer 776 may have a germanium content that varies from zero percent at the substrate 744 to a nonzero percent (e.g., 70%) at the barrier layer 754-1. The barrier layer 754-1 may in turn have a germanium content equal to the nonzero percent. In other embodiments, the buffer layer 776 may have a germanium content equal to the germanium content of the barrier layer 754-1 but may be thicker than the barrier layer 754-1 to absorb the defects that arise during growth. In some embodiments of the quantum well stack 746 of FIG. 9C, the buffer layer 776 and/or the barrier layer 754-2 may be omitted.

FIG. 10 is a top view of a wafer 450 and dies 452 that may be formed from the wafer 450; the dies 452 may be included in the control circuitry 104 and/or the qubit circuitry 106 discussed herein. The wafer 450 may include semiconductor material and may include one or more dies 452 having conventional and/or QC device elements formed on a surface of the wafer 450. Each of the dies 452 may be a repeating unit of a semiconductor product that includes any suitable conventional and/or QC device. After the fabrication of the semiconductor product is complete, the wafer 450 may undergo a singulation process in which each die 452 is separated from the others to provide discrete "chips" of the semiconductor product. A die 452 may include one or more QC devices (e.g., the devices discussed above with reference to FIGS. 6-9) and/or supporting circuitry to route electrical signals to the QC devices (e.g., interconnects including vias and lines, or control circuitry), as well as any other integrated circuit components. In some embodiments, the wafer 450 or the die 452 may include a memory device (e.g., a static random access memory (SRAM) device), a logic device (e.g., AND, OR, NAND, or NOR gate), or any other suitable circuit element. Multiple ones of these devices may be combined on a single die 452. For example, a memory array formed by multiple memory devices may be formed on a same die 452 as a processing device (e.g., the processing device 2002 of FIG. 11) or other logic that is configured to store information in the memory devices or execute instructions stored in the memory array.

FIG. 11 is a block diagram of an example QC system 2000 that may be implemented by the QC systems 100 disclosed herein. A number of components are illustrated in FIG. 11 as included in the QC system 2000, but any one or more of these components may be omitted or duplicated, as suitable for the application. In some embodiments, some or all the components included in the QC system 2000 may be attached to one or more PCBs (e.g., a motherboard). In some embodiments, various ones of these components may be fabricated onto a single system-on-a-chip (SoC) die. Additionally, in various embodiments, the QC system 2000 may not include one or more of the components illustrated in FIG. 11, but the QC system 2000 may include interface circuitry for coupling to the one or more components. For example, the QC system 2000 may not include a display device 2006, but may include display device interface circuitry (e.g., a connector and driver circuitry) to which a display device 2006 may be coupled. In another set of examples, the QC system 2000 may not include an audio input device 2024 or an audio output device 2008, but may include audio input or output device interface circuitry (e.g., connectors and supporting circuitry) to which an audio input device 2024 or audio output device 2008 may be coupled.

The QC system 2000 may include a processing device 2002 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 2002 may include a quantum processing device 2026 (e.g., one or more quantum processing devices), and a non-quantum processing device 2028 (e.g., one or more non-quantum processing devices). The quantum processing device 2026 may include the qubit circuitry 106 of one or more QC modules 128, and the non-quantum processing device 2028 may include the control circuitry 104 of one or more QC modules 128 (and may also include some or all of the external electronic circuitry 108). The quantum processing device 2026 may include one or more of the dies disclosed herein, and may perform data processing by performing operations on the qubits that may be generated in the dies, and monitoring the result of those operations. For example, as discussed above, different qubits may be allowed to interact, the quantum states of different qubits may be set or transformed, and the quantum states of qubits may be read. The quantum processing device 2026 may be a universal quantum processor, or specialized quantum processor configured to run one or more particular quantum algorithms. In some embodiments, the quantum processing device 2026 may execute algorithms that are particularly suitable for quantum computers, such as cryptographic algorithms that utilize prime factorization, encryption/decryption, algorithms to optimize chemical reactions, algorithms to model protein folding, etc. The quantum processing device 2026 may also include support circuitry to support the processing capability of the quantum processing device 2026, such as input/output channels, multiplexers, signal mixers, quantum amplifiers, etc.

As noted above, the processing device 2002 may include a non-quantum processing device 2028. In some embodiments, the non-quantum processing device 2028 may provide peripheral logic to support the operation of the quantum processing device 2026. For example, the non-quantum processing device 2028 may control the performance of a read operation, control the performance of a write operation, control the clearing of quantum bits, control the performance of any of the operations discussed herein, etc. The non-quantum processing device 2028 may also perform conventional computing functions to supplement the computing functions provided by the quantum processing device 2026. For example, the non-quantum processing device 2028 may interface with one or more of the other components of the QC system 2000 (e.g., the communication chip 2012 discussed below, the display device 2006 discussed below, etc.) in a conventional manner, and may serve as an interface between the quantum processing device 2026 and conventional components. The non-quantum processing device 2028 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices.

The QC system 2000 may include a memory 2004, which may itself include one or more memory devices such as volatile memory (e.g., dynamic random access memory (DRAM)), nonvolatile memory (e.g., read-only memory (ROM)), flash memory, solid state memory, and/or a hard drive. In some embodiments, the states of qubits in the quantum processing device 2026 may be read and stored in the memory 2004. In some embodiments, the memory 2004 may include memory that shares a die with the non-quantum processing device 2028. This memory may be used as cache memory and may include embedded dynamic random access memory (eDRAM) or spin transfer torque magnetic random access memory (STT-MRAM).

The QC system 2000 may include one or more cooling apparatus 2030 (e.g., any of the refrigerators 102 discussed herein). The cooling apparatus 2030 may maintain the quantum processing device 2026 at a predetermined low temperature during operation to reduce the effects of scattering in the quantum processing device 2026.

In some embodiments, the QC system 2000 may include a communication chip 2012 (e.g., one or more communication chips). For example, the communication chip 2012 may be configured for managing wireless communications for the transfer of data to and from the QC system 2000. The term "wireless" and its derivatives may be used to describe circuits, devices, systems, methods, techniques, communications channels, etc. that may communicate data through the use of modulated electromagnetic radiation through a nonsolid medium. The term does not imply that the associated devices do not contain any wires, although in some embodiments they might not.

The communication chip 2012 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2012 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 2012 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 2012 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 2012 may operate in accordance with other wireless protocols in other embodiments. The QC system 2000 may include an antenna 2022 to facilitate wireless communications and/or to receive other wireless communications (such as AM or FM radio transmissions).

In some embodiments, the communication chip 2012 may manage wired communications, such as electrical, optical, or any other suitable communication protocols (e.g., the Ethernet). As noted above, the communication chip 2012 may include multiple communication chips. For instance, a first communication chip 2012 may be dedicated to shorter-range wireless communications such as Wi-Fi or Bluetooth, and a second communication chip 2012 may be dedicated to longer-range wireless communications such as global positioning system (GPS), EDGE, GPRS, CDMA, WiMAX, LTE, EV-DO, or others. In some embodiments, a first communication chip 2012 may be dedicated to wireless communications, and a second communication chip 2012 may be dedicated to wired communications.

The QC system 2000 may include battery/power circuitry 2014. The battery/power circuitry 2014 may include one or more energy storage devices (e.g., batteries or capacitors) and/or circuitry for coupling components of the QC system 2000 to an energy source separate from the QC system 2000 (e.g., AC line power).

The QC system 2000 may include a display device 2006 (or corresponding interface circuitry, as discussed above). The display device 2006 may include any visual indicators, such as a heads-up display, a computer monitor, a projector, a touchscreen display, a liquid crystal display (LCD), a light-emitting diode display, or a flat panel display.

The QC system 2000 may include an audio output device 2008 (or corresponding interface circuitry, as discussed above). The audio output device 2008 may include any device that generates an audible indicator, such as speakers, headsets, or earbuds, for example.

The QC system 2000 may include an audio input device 2024 (or corresponding interface circuitry, as discussed above). The audio input device 2024 may include any device that generates a signal representative of a sound, such as microphones, microphone arrays, or digital instruments (e.g., instruments having a musical instrument digital interface (MIDI) output).

The QC system 2000 may include a GPS device 2018 (or corresponding interface circuitry, as discussed above). The GPS device 2018 may be in communication with a satellite-based system and may receive a location of the QC system 2000, as known in the art.

The QC system 2000 may include an other output device 2010 (or corresponding interface circuitry, as discussed above). Examples of the other output device 2010 may include an audio codec, a video codec, a printer, a wired or wireless transmitter for providing information to other devices, or an additional storage device.

The QC system 2000 may include an other input device 2020 (or corresponding interface circuitry, as discussed above). Examples of the other input device 2020 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The following paragraphs provide various examples of the embodiments disclosed herein.
Example 1 is a quantum computing assembly, including: control circuitry, wherein the control circuitry includes a first interface to qubit circuitry and a second interface to external electronic circuitry, and the second interface is an optical interface.
Example 2 includes the subject matter of Example 1, and further specifies that the optical interface includes one or more lasers.
Example 3 includes the subject matter of Example 2, and further specifies that the one or more lasers includes a plurality of lasers, and the optical interface is to multiplex outputs of the plurality of lasers onto a single optical cable.
Example 4 includes the subject matter of Example 2, and further specifies that the one or more lasers includes a plurality of lasers, and the optical interface is to provide outputs of the plurality of lasers to a corresponding plurality of optical cables.
Example 5 includes the subject matter of any of Examples 1-4, and further specifies that the optical interface includes one or more photodetectors.
Example 6 includes the subject matter of any of Examples 1-5, and further includes: one or more optical cables coupled to the optical interface.
Example 7 includes the subject matter of any of Examples 1-6, and further specifies that the optical interface includes an optical connector for a refrigerator.
Example 8 includes the subject matter of any of Examples 1-7, and further includes: the qubit circuitry.
Example 9 includes the subject matter of Example 8, and further specifies that the qubit circuitry is coupled to the first interface by digital cables, analog cables, or radio frequency (RF) cables.
Example 10 includes the subject matter of any of Examples 8-9, and further specifies that the qubit circuitry includes spin qubit-type quantum devices.
Example 11 includes the subject matter of any of Examples 8-10, and further specifies that the qubit circuitry includes superconducting qubit-type quantum devices.
Example 12 includes the subject matter of any of Examples 8-11, and further includes: a refrigerator, wherein the qubit circuitry is in a first stage of the refrigerator, at least some of the control circuitry is in a second stage of the refrigerator, and the second stage is warmer than the first stage.
Example 13 includes the subject matter of any of Examples 1-12, and further includes: a refrigerator, wherein the first interface is in a first stage of the refrigerator, the second interface is in a second stage of the refrigerator, and the second stage is warmer than the first stage.
Example 14 includes the subject matter of any of Examples 1-13, and further includes: the external electronic circuitry.
Example 15 includes the subject matter of Example 14, and further specifies that the control circuitry is inside a refrigerator and the external electronic circuitry is outside the refrigerator.
Example 16 includes the subject matter of any of Examples 1-15, and further specifies that the control circuitry is to control signals applied to qubit elements of the qubit circuitry.
Example 17 includes the subject matter of any of Examples 1-16, and further specifies that the control circuitry includes a memory device to store data generated by qubit elements during operation of the qubit circuitry.
Example 18 includes the subject matter of any of Examples 1-17, and further specifies that the control circuitry includes a memory device to store instructions for a quantum computing algorithm to be executed by the qubit circuitry.
Example 19 is a quantum computing assembly, including: a refrigerator including a first stage and a second stage, wherein the first stage is colder than the second stage; qubit circuitry, wherein the qubit circuitry is in the first stage; and control circuitry including an optical interface to external electronic circuitry, wherein the optical interface is in the second stage, and the control circuitry is communicatively coupled to the qubit circuitry.
Example 20 includes the subject matter of Example 19, and further specifies that the control circuitry includes a digital or mixed-signal controller, and the controller is in the second stage.
Example 21 includes the subject matter of Example 19, and further specifies that the refrigerator includes a third stage between the first stage and the second stage, the third stage is warmer than the first stage and colder than the second stage, the control circuitry includes a controller, and the controller is in the third stage.
Example 22 includes the subject matter of Example 19, and further specifies that the optical interface includes one or more lasers.
Example 23 includes the subject matter of Example 22, and further specifies that the one or more lasers includes a plurality of lasers, and the optical interface is to multiplex outputs of the plurality of lasers onto a single optical cable.
Example 24 includes the subject matter of Example 22, and further specifies that the one or more lasers includes a plurality of lasers, and the optical interface is to provide outputs of the plurality of lasers to a corresponding plurality of optical cables.
Example 25 includes the subject matter of any of Examples 19-24, and further specifies that the optical interface includes one or more photodetectors.
Example 26 includes the subject matter of any of Examples 19-25, and further includes: one or more optical cables coupled to the optical interface.
Example 27 includes the subject matter of any of Examples 19-26, and further specifies that the optical interface includes an optical connector for a refrigerator.
Example 28 includes the subject matter of any of Examples 19-27, and further specifies that the qubit circuitry is communicatively coupled to the control circuitry by digital cables, analog cables, or radio frequency (RF) cables.
Example 29 includes the subject matter of any of Examples 19-28, and further specifies that the qubit circuitry includes spin qubit-type quantum devices.
Example 30 includes the subject matter of any of Examples 19-29, and further specifies that the qubit circuitry includes superconducting qubit-type quantum devices.
Example 31 includes the subject matter of any of Examples 19-30, and further includes: the external electronic circuitry.
Example 32 includes the subject matter of Example 31, and further specifies that the control circuitry is inside a refrigerator and the external electronic circuitry is outside the refrigerator.
Example 33 includes the subject matter of any of Examples 19-32, and further specifies that the control circuitry is to control signals applied to qubit elements of the qubit circuitry.
Example 34 includes the subject matter of any of Examples 19-33, and further specifies that the control circuitry includes a memory device to store data generated by qubit elements during operation of the qubit circuitry.
Example 35 includes the subject matter of any of Examples 19-34, and further specifies that the control circuitry includes a memory device to store instructions for a quantum computing algorithm to be executed by the qubit circuitry.
Example 36 is a quantum computing assembly, including: a first refrigerated system, wherein the first refrigerated system includes a first refrigerator with first qubit circuitry and first control circuitry therein, the first qubit circuitry is at a colder stage in the first refrigerator than the first control circuitry, and the first control circuitry includes a first optical interface; a second refrigerated system, wherein the second refrigerated system includes a second refrigerator with second qubit circuitry and second control circuitry therein, the second qubit circuitry is at a colder stage in the second refrigerator than the second control circuitry, and the second control circuitry includes a second optical interface; and external electronic circuitry, wherein the first control circuitry is communicatively coupled to the external electronic circuitry via the first optical interface, and the second control circuitry is communicatively coupled to the external electronic circuitry via the second optical interface.
Example 37 includes the subject matter of Example 36, and further specifies that the first control circuitry is included in a single stage of the first refrigerator.
Example 38 includes the subject matter of Example 36, and further specifies that the first control circuitry is distributed across multiple stages of the first refrigerator.
Example 39 includes the subject matter of any of Examples 36-38, and further specifies that the first optical interface includes one or more lasers.
Example 40 includes the subject matter of Example 39, and further specifies that the one or more lasers includes a plurality of lasers, and the first optical interface is to multiplex outputs of the plurality of lasers onto a single optical cable.
Example 41 includes the subject matter of Example 39, and further specifies that the one or more lasers includes a plurality of lasers, and the first optical interface is to provide outputs of the plurality of lasers to a corresponding plurality of optical cables.
Example 42 includes the subject matter of any of Examples 36-41, and further specifies that the first optical interface includes one or more photodetectors.
Example 43 includes the subject matter of any of Examples 36-42, and further specifies that the first optical interface includes an optical connector for a refrigerator.
Example 44 includes the subject matter of any of Examples 36-43, and further specifies that the first qubit circuitry is communicatively coupled to the first control circuitry by digital cables, analog cables, or radio frequency (RF) cables.
Example 45 includes the subject matter of any of Examples 36-44, and further specifies that the first qubit circuitry includes spin qubit-type quantum devices.
Example 46 includes the subject matter of any of Examples 36-45, and further specifies that the first qubit circuitry includes superconducting qubit-type quantum devices.
Example 47 includes the subject matter of any of Examples 36-46, and further specifies that the external electronic circuitry is outside the first refrigerator and outside the second refrigerator.
Example 48 includes the subject matter of any of Examples 36-47, and further specifies that the first control circuitry is to control signals applied to qubit elements of the first qubit circuitry.
Example 49 includes the subject matter of any of Examples 36-48, and further specifies that the first control circuitry includes a memory device to store data generated by qubit elements during operation of the first qubit circuitry.
Example 50 includes the subject matter of any of Examples 36-49, and further specifies that the external electronic circuitry includes a memory device to store instructions for a quantum computing algorithm to be executed by the first qubit circuitry.

## Claims

1. A quantum computing assembly, comprising:
control circuitry, wherein the control circuitry includes a first interface to qubit circuitry and a second interface to external electronic circuitry, and the second interface is an optical interface.

2. The quantum computing assembly of claim 1, wherein the optical interface includes one or more lasers.

3. The quantum computing assembly of claim 2, wherein the one or more lasers includes a plurality of lasers, and the optical interface is to multiplex outputs of the plurality of lasers onto a single optical cable.

4. The quantum computing assembly of claim 2, wherein the one or more lasers includes a plurality of lasers, and the optical interface is to provide outputs of the plurality of lasers to a corresponding plurality of optical cables.

5. The quantum computing assembly of any of claims 1-4, wherein the optical interface includes one or more photodetectors.

6. The quantum computing assembly of any of claims 1-5, further comprising:
one or more optical cables coupled to the optical interface.

7. The quantum computing assembly of any of claims 1-6, wherein the optical interface includes an optical connector for a refrigerator.

8. The quantum computing assembly of any of claims 1-7, further comprising the qubit circuitry, where the qubit circuitry is coupled to the first interface by digital cables, analog cables, or radio frequency (RF) cables.

9. The quantum computing assembly of claim 8, wherein the qubit circuitry includes spin qubit-type quantum devices.

10. The quantum computing assembly of claim 8, wherein the qubit circuitry includes superconducting qubit-type quantum devices.

11. The quantum computing assembly of any of claims 1-10, further comprising:
a refrigerator, wherein the first interface is in a first stage of the refrigerator, the second interface is in a second stage of the refrigerator, and the second stage is warmer than the first stage.

12. The quantum computing assembly of any of claims 1-11, further comprising:
the external electronic circuitry.

13. The quantum computing assembly of claim 12, wherein the control circuitry is inside a refrigerator and the external electronic circuitry is outside the refrigerator.

14. The quantum computing assembly of any of claims 1-13, wherein the control circuitry includes a memory device to store data generated by qubit elements during operation of the qubit circuitry.

15. The quantum computing assembly of any of claims 1-14, wherein the control circuitry includes a memory device to store instructions for a quantum computing algorithm to be executed by the qubit circuitry.
